# EUROPEAN PATENT SPECIFICATION

(11) **EP 0 438 905 B1**
(45) Date of publication and mention of the grant of the patent: **28.08.1996**
(21) Application number: 90314115.8
(22) Date of filing: 21.12.1990
(51) Int. Cl.: H01L 23/043

(54) **IC package having replaceable backup battery**
IC-Gehäuse mit austauschbarer Reservebatterie
Emballage IC ayant une batterie interchangeable de réserve

(30) Priority: 26.01.1990 US 470939
(43) Date of publication of application: 31.07.1991
(73) Proprietor: SGS-THOMSON MICROELECTRONICS, INC., Carrollton Texas 75006 (US)
(72) Inventor: Hundt, Michael J., Lewisville, Texas 75067 (US)
(74) Representative: Palmer, Roger

(56) References cited:
- GB-A- 1 555 364
- US-A- 4 142 287
- US-A- 4 538 660
- US-A- 4 646 132

## Description

This invention relates generally to packaging for semiconductor devices, and in particular to an integrated circuit package which supports a semiconductor memory chip and a backup battery for preserving data in the event of loss of main power supply.

Conventional electronic circuit packages for semiconductor integrated circuit chips are adapted to enclose and seal the chip devices, while also providing heat dissipation, structural support, electrical attachment of device leads to external pin connectors, and electrical interconnection with other devices in the package. Such packages are usually formed of one or more layers of a non-conductive material, having a central cavity in which a semiconductor chip is received. Flexible metal leads are extended from the central cavity for connecting the device input/output leads to a printed circuit board in a host electronic circuit.

An important integrated circuit product which is implemented on an IC chip encapsulated within an integrated circuit package includes a volatile semiconductor memory such as the static random access memory (SRAM) which is characterized by low power consumption and high memory cell density. The generation of valid logic signals and the retention of data in such integrated memory circuits having volatile memory cells depend in part on maintenance of power supply voltages within specified limits. In conventional integrated circuit memory devices, internal circuits sense the external voltage being applied to determine if it is sufficient for reliable operation. In response to a low voltage condition, control signals are generated which cause active chips to be de-selected and maintained in standby condition. This is usually carried out by means of true and complement chip select signals, CS and $\overline{\text{CS}}$, respectively, which inhibit read/write operations until the low voltage condition has been corrected.

During the period that a memory chip is in the unselected condition it is necessary to maintain the charge levels of the storage capacitors in the volatile memory cells so that stored data will be retained. Otherwise, the information stored in the memory cells, including programs and data, will be lost when main power is removed. Although the loss of power does not result in memory circuit damage, the loss of stored information requires that the memory be reloaded with programs and data before processing can be reestablished.

It has been proposed to solve the data loss problem by using an additional pin terminal on memory semiconductor circuits and that the additional terminal be supplied with backup power from a remote source to maintain the data in the memory cells. However, there are now established standardized pin patterns for most integrated circuit memories; consequently, the addition of another pin dedicated to a remote backup power supply would not be compatible with standard pin patterns, and would require a substantial redesign of existing circuits.

Accordingly, there exists a need for a semiconductor memory package for supporting a memory chip and a backup battery wherein the socket area and standard pin configuration are not affected, and stored data are retained despite a loss of the main power supply.

A substantial portion of the cost and size of a packaged chip is attributable to package fabrication, and two important design criteria in addition to providing a reliable electrical connection are cost effectiveness and space efficiency. A need thus exists for an improved device package for safely supporting an integrated circuit chip and an on-package backup battery wherein the package is provided with pin connectors formed therein for plug-in compatibility with standard printed circuit sockets, and the packaging space required for supporting the backup battery is minimized.

Packages are needed for integrated circuit memory devices which include a battery molded within the body of the package. However, when the assembly is heated to the temperature necessary to perform encapsulation, the electrolyte within the backup battery evaporates and the battery charge is destroyed. Accordingly, there is continuing interest in developing backup batteries which can withstand the high temperatures encountered during transfer molding and encapsulation. Until such batteries have been perfected, there is a need for an IC chip package which will permit a backup battery to be loaded after molding and encapsulation have been completed.

US-A-4539660 discloses a semiconductor integrated circuit including a memory chip, mounted within a body of non-conductive material. The body supports plural connector pins, and has a first connection for a first power terminal of a battery and a second connection for a second power terminal of the battery. In Figures 6 and 7, circuitry, in the form of conductive leads, connect the battery to connector pins of the circuit.

Although backup batteries are presently available which are rated for backup use for 10 years or more, the user may desire to replace the backup battery from time-to-time. For example, the user may desire to use a less expensive battery having a shorter life span and replace it from time-to-time, or replace an on-board backup battery with an improved backup battery when it becomes available. Additionally, the user may desire to substitute a new battery for an on-board backup battery which has been discharged by a short circuit or which otherwise has been damaged, for example, by exposure to high temperature operating conditions.

According to a first aspect of the present invention there is provided an electronic circuit package comprising a body of non-conductive material, said body supporting plural connector pins; a first connection for a first power terminal of a backup battery and a second connection for a second power terminal of said battery; an integrated circuit device encapsulated within said body of non-conductive material, said integrated circuit device having nodes connected to said first and second connections; and a finger lead assembly encapsulated within said body of non-conductive material, said finger lead assembly including a plurality of conductive finger leads, characterised by said body of non-conductive material having a shoulder portion defining an external socket cavity for receiving said battery; a first finger lead being said first connection and a second finger lead being said second connection, one of said first and second finger leads having a terminal contact portion projecting externally of said body of non-conductive material for spring-biassed electrical contacting engagement with said first power terminal, and for spring-biassed retention of said battery in said external socket cavity; said terminal contact portion (18R) being deflectable for battery insertion and removal; and said body of non-conductive material being intersected by a battery connection cavity in open alignment with said battery socket cavity, said battery connection cavity exposing the other of said first and second finger leads for electrical contacting engagement with the second power terminal of said battery.

Thus there is disclosed a package for encapsulating an integrated circuit device and overcomes the foregoing backup power limitations of the prior art by providing an integrally formed external socket for receiving a replaceable backup battery which can be manually inserted into or removed from the socket after molding encapsulation and metal trim work have been completed. In an embodiment, a lead frame assembly including a base plate and multiple finger leads is secured onto a side surface of a first body of non-conductive material during a transfer mold operation. A second molded body of non-conductive material having a chip cavity and a battery cavity is assembled onto the first body, with the chip cavity being positioned in alignment with the base plate of the lead frame assembly, and with the battery cavity exposing a portion of a conductive power lead of the lead frame assembly.

The second molded body of non-conductive material includes shoulder portions defining a socket aligned with the battery cavity for receiving a backup battery of the type having positive and negative polarity contact members. The backup battery is manually insertable into the socket, with its negative polarity contact member being received within the battery cavity and engaged in electrical contact with the exposed conductive power lead. A second conductive power lead includes a resilient terminal contact portion which is disposed in electrical contacting engagement with the positive polarity contact member of the backup battery. The terminal contact portion of the second conductive power lead also serves as a retainer in combination with the socket shoulder portions for retaining the backup battery within the socket.

According to a second aspect of the present invention there is provided a method of manufacture of an electronic circuit package comprising forming a first body of non-conductive material, having a support surface; mounting a finger lead assembly onto said support surface, said finger lead assembly including a plurality of conductive finger leads, one of said finger leads (18P) defining a positive battery lead and one of said finger leads (18N) defining a negative battery lead, and another of said battery leads having a terminal contact portion (18R) projecting externally of said first body of non-conductive material; assembling a second body of non-conductive material onto said first body of non-conductive material whereby said finger lead assembly is confined therebetween and said second body is intersected by a device cavity for receiving an integrated circuit device; disposing an integrated circuit device within said device cavity and connecting a plurality of input/output nodes of said integrated circuit device to said conductive finger leads; wherein said second body of non-conductive material is intersected by a battery connection cavity exposing the other of said battery leads, and said second body of non-conductive material has shoulder portions defining a socket cavity for receiving a backup battery; and further comprising the step of inserting a backup battery in said battery connection cavity, whereby said battery has a first contact terminal in electrical contact with said other battery lead and a second contact terminal electrically contacted by said externally projecting terminal contact portion (18R), such that said externally projecting terminal contact portion (18R) affords spring-biassed engagement with said second contact terminal of said battery and spring-biassed retention of said battery in said cavity.

Operational features and advantages of the present invention will be appreciated by those skilled in the art upon reading the detailed description which follows in connection with the attached drawings, wherein:
FIGURE 1 is a perspective view of an integrated circuit chip package having a replaceable backup battery according to the present invention;
FIGURE 2 is a plan view of a lead frame assembly which is incorporated in the semiconductor package of FIGURE 1;
FIGURE 3 is a perspective view of the semiconductor package shown in FIGURE 1, partially broken away, with the backup battery removed from its socket; and,
FIGURE 4 is a side elevational view, partially broken away and partially in section, of the integrated circuit package of FIGURE 1.

In the description which follows, like parts are indicated throughout the specification and drawings with the same reference numerals, respectively. By way of example, the invention is described in combination with a static random access memory (SRAM) which is implemented by monolithic CMOS/LSI techniques on a N-type silicon semiconductor clip. It will be appreciated, however, that the packaging assembly of the invention may be used to encapsulate and provide replaceable backup battery power for discrete as well as integrated devices, but has particular utility for volatile memory integrated circuits having multiple input/output nodes. Accordingly, it should be understood that the invention in its broadest aspects may be incorporated in any moldable package which houses one or more circuit devices requiring backup power, including but not limited to discrete, micro-discrete and integrated circuit components, and hybride combinations of discrete and integrated devices.

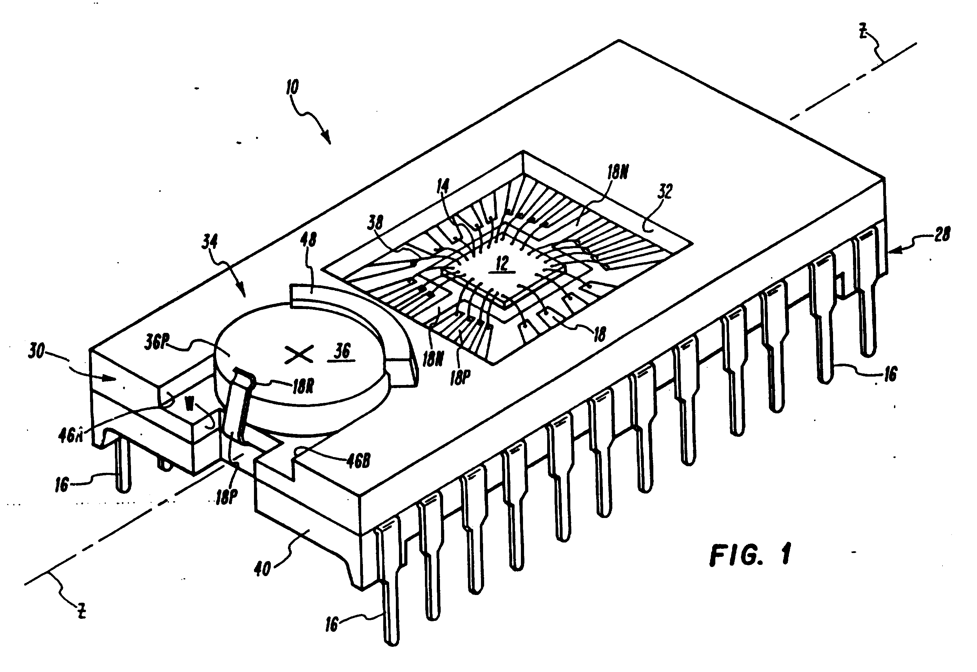

Referring now to FIGURE 1, there is shown an exemplary semiconductor chip package 10 incorporating the present invention. The package 10 supports and encapsulates an integrated circuit chip 12 having input/output nodes 14. The IC chip 12 may be, for example, a 2K x 8 static random access memory (SRAM) circuit which is characterized by low power consumption, high memory cell density and which is implemented by complementary metal oxide semiconductor (CMOS) technology.

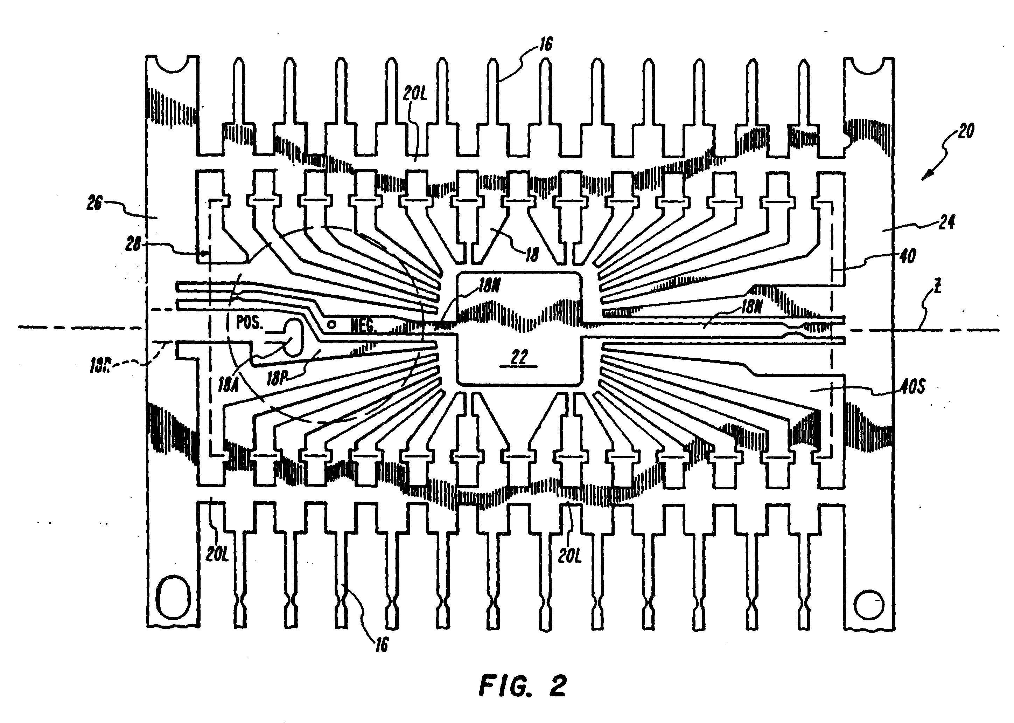

The exemplary package 10 has a conventional dual-in-line pin configuration including 24 external connector pins arranged. in two parallel rows with 600 mil spacing along the longitudinal edges of the package. The input/output nodes 14 of the integrated circuit chip 12 are electrically connected to selected connector pins 16 by conductive finger leads 18 of a lead frame assembly 20 as shown in FIGURE 2.

Referring to FIGURE 2, the inner lead fingers 18 are spaced with respect to a central base plate 22 and are integrally formed with the connector pins 16. Connecting portions 20L of the lead frame assembly are ultimately trimmed away during manufacture, whereby each inner lead 18 is electrically connected to a single connector pin 16. Transport side rail strips 24, 26 on the outer perimeter of the lead frame 20 are also cut away during trim and form operations in the last stages of manufacture, after molding has taken place.

The inner tips of the conductive fingers 18 are symmetrically spaced about the base plate 22. The inner tips of the conductive fingers 18 are relatively narrow, and the fingers expand substantially as they radiate outwardly from the base plate 22. The base plate 22, connector pins 16 and inner finger leads 18 are initially coplanar during molding. After molding, the connector pin portions 16 are bent through a 90 degree angle along the longitudinal side surfaces of the package during the trim and form operation.

The semiconductor chip package includes a pin sub-assembly 28 and a cover sub-assembly 30. The pin sub-assembly 28 provides a standard pin pattern for electrically connecting the input/output nodes 14 of the semi-conductor chip 12 to a socket on a printed circuit board of a host electronic system or on some other semiconductor package. The cover sub-assembly 30 includes a non-conductive substrate wafer 31 which is assembled onto the pin sub-assembly 28, and seals the lead frame assembly 20. Additionally, the cover sub-assembly 30 includes a cavity 32 in wafer substrate 31 in which the semiconductor chip 12 is received and a socket 34 for receiving a backup battery 36.

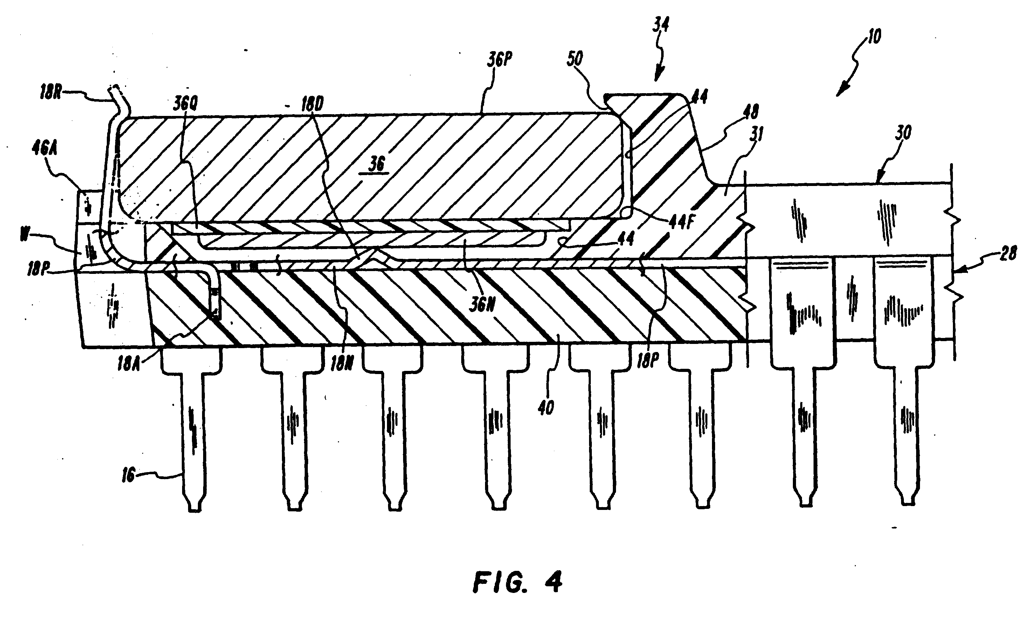

The battery 36 is preferably a 3-volt lithium cell having a 12 mm diameter. The battery 36 has a positive terminal 36P and a negative terminal 36N which is insulated with respect to the positive terminal by an annular layer of dielectric insulation 36Q, as shown in FIGURE 4.

The semiconductor chip 12 is bonded to the base plate 22 by a conductive deposit of silver-filled epoxy adhesive such as Ablebond™ 84-1 which secures the chip 12 within the cavity 32. The input/output nodes 14 are electrically connected to selected ones of the conductive fingers 18 by fine gold wires 38 having a diameter of 33 µm (1.3 mil). Bonding of the gold wires 38 to the conductive fingers 18 and I/O nodes 14 is preferably by the conventional thermosonic ball bonding technique.

After the integrated circuit chip 12 has been bonded to the base plate 22, and the ends of the fine gold wires 38 have been bonded, the lead frame assembly 20 is placed into the bottom half of a multi-cavity split mold. The mold cavity is closed in a transfer molding machine and a non-conductive encapsulant material such as polyphenolene sulfide is injected in fine pellet form from a nozzle. The pressure at which this injection takes place is closely controlled to prevent damage to the wire bonds. Under the appropriate pressure and temperature, for example, 200° C, the pellets melt and flow into channels within the mold and fill the cavities around the lead frame assembly 20. The resin is cured while still in the mold by the applied heat and pressure. Further curing takes place in an oven.

As a result of the foregoing mold procedure, the pin assembly 28 is produced in the form of an elongate, generally rectangular wafer body 40 of non-conductive material, with the lead frame 20 being embedded in flush relation with the top surface 40S of the rectangular body as shown in FIGURE 2. The lead frame 20 is further stabilized onto the pin assembly 28 by an anchor 18A which is embedded within the wafer body 40 during molding. The anchor tab 18A is integrally formed as a part of the positive finger lead 18P, and is stamped in the form of T outline as shown in FIGURE 2 during fabrication the lead frame assembly 20. Prior to molding, the anchor tab 18A is turned downwardly through an angle of approximately 90 degrees, thereby securely anchoring the lead frame assembly 20 onto the top surface 40S of the non-conductive wafer substrate 40. After removal from the mold, the lateral cross pieces 20L between adjacent pins 16 in the lead frame assembly 20 are cut to separate and electrically isolate the pins and conductive finger strips from one another. Additionally, the transport side sections 24, 26 are also cut and separated from the molded assembly.

The lead frame 20 material preferably comprises a conventional metal material, such as a tin-plated nickel or iron alloy or, alternatively, a tin-plated copper alloy such as CDA 194. It will be appreciated that during assembly, the connector pins and inner conductive leads are structurally interconnected by the lateral segments 20L and by the side transport sections 24, 26, preferably stamped from the same metal strip. The connecting sections remain attached to the connector pins for handling purposes only and are severed prior to ultimate use.

A measured amount of a liquid encapsulating material, such as Amicon XT-5038-9 insulation compound (not shown), is injected into the cavity 32 for sealing and protecting the integrated circuit chip 12, the gold bond wires 38 and the exposed surfaces of the inner finger leads 18. The liquid encapsulating material solidifies upon curing, thereby providing structural cover as well as an environmental seal.

It will be understood that a selected one of the external pins 16 will be connected to a primary power supply node which provides a voltage V_{CC} which is typically at +5.0 volts DC. Similarly, another connector pin will be connected to a ground node of a host electronic system for providing a ground-reference GND. Other pins are dedicated for true and complement chip select signals, CS and $\overline{\text{CS}}$, a signal CLK for synchronously clocking data to and from the monolithic integrated circuit 12, as well as various other I/O signals which are produced by the host electronic circuit. A comparator and switching circuit (not illustrated) compares the voltage V_{CC} from the primary power supply of the host electronic circuit with the voltage of the backup battery 36 and automatically connects the highest detected voltage to power the integrated circuit 12.

According to one aspect of the invention, one of the conductive inner finger leads, designated 18N, is integrally formed with the base plate 22. The finger lead 18N extends across the lead frame support surface 40S generally along the longitudinal axis Z of the sub-assembly 40. Another one of the conductive inner finger leads, designated 18P, is radially spaced and isolated from the base plate 22, and also extends generally, in alignment with the longitudinal axis Z of the pin sub-assembly 28. The inner conductive finger leads 18P and 18N are adapted for electrical contacting engagement with the positive terminal 36P and negative terminal 36N of the replaceable backup battery 36 as illustrated in FIGURE 4.

In the preferred embodiment, electrical connection to the positive and negative terminals 36P, 36N of the replaceable backup battery 36 is accomplished by engaging the negative battery terminal 36N against the negative conductive lead 18N, as shown in FIGURE 4. The positive terminal 36P is electrically engaged by a modified terminal end portion 18R of the positive inner lead 18P. Referring to FIGURE 2 and FIGURE 4, the side rail 26 is cut during a post molding cut and form operation to provide the extended terminal end portion 18R. A notch W is formed in the non-conductive substrate wafer 31 of cover sub-assembly 30 to accommodate flexure movement of the positive terminal end portion 18R. The terminal end portion 18R is bent vertically through the notch W as shown in FIGURE 4 through an angle of approximately 120°, toward the socket 34, whereby the terminal end portion 18R applies a spring bias force against the positive contact surface 36P of the replaceable backup battery 36. The replaceable battery 36 is therefore securely received within the socket 34 which forms a part of the cover sub-assembly 30.

In one embodiment of the invention, the non-conductive wafer substrate 31 of the cover sub-assembly 30 is separately molded in a transfer molding machine in which non-conductive encapsulate material such as polyphenylene sulfide is injected. The mold cavity is provided with the appropriate mold structure to produce the chip cavity 32, a battery interface cavity 42, a socket cavity 44, the notch W, and a rectangular slot 46. After molding, the cover sub-assembly 30 is securely bonded onto the lead frame support surface 40S with the integrated circuit chip 12 centered within the chip cavity 32, and with the battery interface cavity 42 providing access to a surface portion of the negative finger lead 18N. The cover sub-assembly substrate 31 is bonded onto the lead frame support surface 40S of the pin sub-assembly 28 by any suitable means such as adhesives, ultrasonic welding, or staking. Accordingly, the interface between the pin sub-assembly 28 and the cover sub-assembly 30 is tightly sealed.

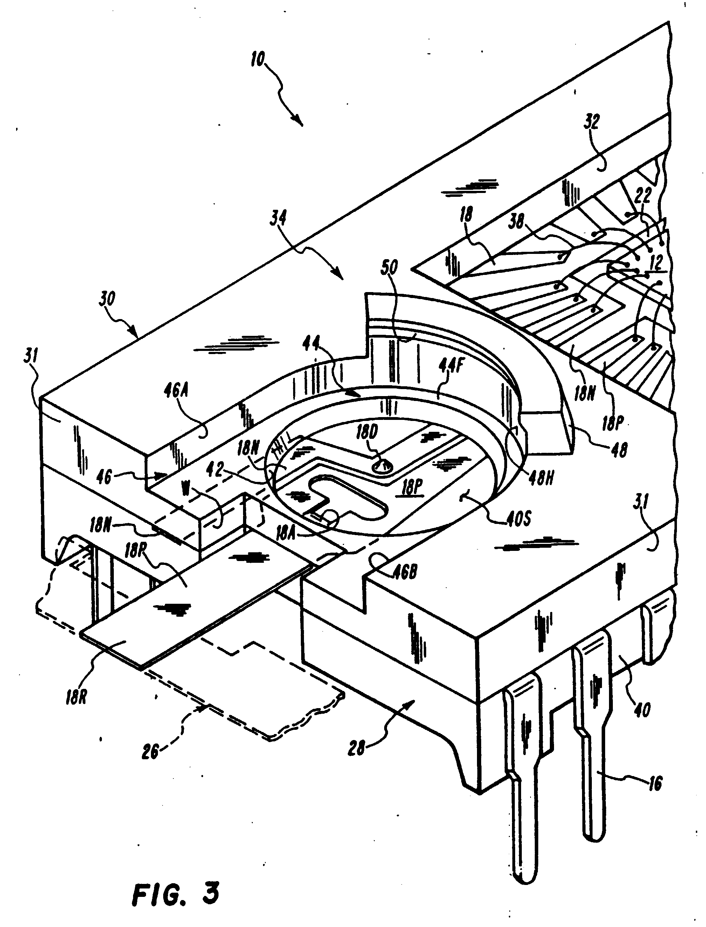

Referring now to FIGURE 3, the socket cavity 44 is substantially concentric with the battery interface cavity 42, and the rectangular slot 46 longitudinally aligned with and opens into the socket cavity 44. The socket cavity 44 is bounded by a semi-cylindrical shoulder 48 which rises above the top of the cover sub-assembly 30. The socket shoulder 48 has a beveled face 50, which in combination with the planar floor surface 44F of the socket cavity 44 receives and retains a side portion of the battery 36. The socket slot sidewalls 46A, 46B provide transverse support for the battery, and have a transverse spacing for receiving a battery having a 12 mm diameter.

During the step of inserting or removing the battery 36, the anode clip terminal portion 18R is deflected outwardly, to permit the battery to be inserted or removed. Upon release, the anode terminal portion 18R springs inwardly and applies a bias retaining force against the edge of the positive anode surface 36P.

Because the positive (anode) finger lead 18P as well as the negative (cathode) finger lead 18N are exposed by the battery interface cavity 42, a contact dimple 18D is formed in the cathode finger lead 18N for engaging the negative cathode terminal 36N of the battery 36. Moreover, multiple finger leads 18 are also exposed by the battery interface cavity 42. Accordingly, an encapsulating material such as Amicon XT-5038-9 insulation compound (not shown) is dispensed into the battery interface cavity 42 and forms a protective insulating layer over the exposed finger leads, but without covering the contact dimple 18D. The insulating layer prevents the formation of conductive bridges across adjacent finger leads 18 which might otherwise occur upon exposure to corrosive fluids. The contact dimple 18D allows electrical contact between the battery cathode, terminal 36N and the negative finger lead 18N while preventing engagement against the other exposed finger leads 18, 18P.

Although the exemplary embodiment illustrated in FIGURES 1-4 utilizes a separately molded pin sub-assembly 22 and a cover sub-assembly 30, it will be understood by those skilled in the art that the pin sub-assembly substrate wafer 40 may be integrally formed with the cover sub-assembly substrate wafer 31 during molding in a multi-cavity split mold. In that molding operation, the lead frame assembly 20 is placed into the bottom half of a multi-cavity split mold, in engagement with appropriately formed standoff structures and cavities to define the socket assembly 34, the battery interface cavity 42, the socket shoulder 48 and the socket slot 46. In the integrally molded embodiment, the chip cavity 32 is not required, and the pressure in which the injection of the non-conductive encapsulant material takes place is closely controlled to prevent damage to the gold wire bonds, with the result that the integrated circuit chip 12, the gold wires 38 and the inner end portions of the finger leads 18 are completely encapsulated. Post molding fabrication of the integrally molded package is otherwise the same, with the positive retainer end terminal 18R being cut, formed and bent into its battery retaining position within notch W as shown in FIGURE 4.

Although the invention has been described with reference to certain specific embodiments, and with reference to a package which encapsulates and provides replaceable backup battery power for an integrated circuit device, the foregoing description is not intended to be construed in a limiting sense. various modifications of the disclosed premolded replaceable battery package as well as alternative applications thereof will be suggested to persons skilled in the art by the foregoing specification and illustrations. The scope of the invention is accordingly to be interpreted by the appended claims.

## Claims

1. An electronic circuit package comprising:-
a body of non-conductive material, said body supporting plural connector pins;
a first connection (18P) for a first power terminal of a backup battery and a second connection (18N) for a second power terminal of said battery;
an integrated circuit device (12) encapsulated within said body of non-conductive material, said integrated circuit device having nodes connected to said first and second connections; and
a finger lead assembly (18) encapsulated within said body of non-conductive material, said finger lead assembly including a plurality of conductive finger leads,
characterised by:-
said body of non-conductive material having a shoulder portion (48) defining an external socket cavity (44) for receiving said battery;
a first finger lead (18P) being said first connection and a second finger lead (18N) being said second connection, one of said first and second finger leads having a terminal contact portion (18R) projecting externally of said body of non-conductive material for spring-biassed electrical contacting engagement with said first power terminal, and for spring-biassed retention of said battery in said external socket cavity; said terminal contact portion (18R) being deflectable for battery insertion and removal; and
said body of non-conductive material being intersected by a battery connection cavity (42) in open alignment with said battery socket cavity (44), said battery connection cavity (42) exposing the other of said first and second finger leads for electrical contacting engagement with the second power terminal of said battery.

2. An electronic circuit package as claimed in claim 1 wherein said finger lead assembly (18) includes a base plate (22) and one of said finger leads (18N) is electrically connected to said base plate (22), one of said nodes of said integrated circuit device (12) being electrically coupled to said base plate (22).

3. An electronic circuit package as claimed in claim 1 or claim 2 wherein said shoulder portion (48) has a semi-cylindrical side wall (48H) defining a side boundary of said socket cavity and said socket cavity (44) has a planar support surface (44F) abutting the semi-cylindrical side wall and defining bottom boundary of the socket cavity (44), wherein said battery connection cavity (42) intersects said planar support surface.

4. An electronic circuit package as defined in any preceding claim wherein the body of non-conductive material has a notch formed on a side edge thereof thereby defining a clearance opening through which the externally projecting terminal contact portion of said first finger leads is extended for engagement with said battery.

5. An electronic circuit package as claimed in any preceding claim, wherein said one of said finger leads has an anchor tab portion (18A) extending transversally with respect to said power lead and embedded within said body of non-conductive material.

6. An electronic circuit package as claimed in any preceding claim, wherein said second finger lead has a conductive dimple formed thereon, disposed within said battery connection cavity (42) for engagement with said battery.

7. An electronic circuit package as claimed in any preceding claim, wherein the integrated circuit device (12) is an LSI integrated circuit having a plurality of input/output nodes and a plurality of wire conductors connecting said input/output nodes to said conductive finger leads.

8. An electronic circuit package as claimed in any one of claims 2-7 wherein said integrated circuit device has a substrate which is bonded to said base plate.

9. A method of manufacture of an electronic circuit package comprising:-
forming a first body (28) of non-conductive material, having a support surface;
mounting a finger lead assembly (18) onto said support surface, said finger lead assembly including a plurality of conductive finger leads, one of said finger leads (18P) defining a positive battery lead and another one of said finger leads (18N) defining a negative battery lead, and one of said battery leads having a terminal contact portion (18R) projecting externally of said first body (28) of non-conductive material;
assembling a second body (31) of non-conductive material onto said first body (28) of non-conductive material whereby said finger lead assembly (18) is confined therebetween and said second body is intersected by a device cavity for receiving an integrated circuit device (12);
disposing an integrated circuit device (12) within said device cavity and connecting a plurality of input/output nodes of said integrated circuit device (12) to said conductive finger leads;
wherein said second body of non-conductive material is intersected by a battery connection cavity (42) exposing the other of said battery leads, and said second body of non-conductive material has shoulder portions (48) defining a socket cavity (44) for receiving a backup battery; and further comprising the step of
inserting a backup battery (36) in said battery connection cavity, whereby said battery has a first contact terminal in electrical contact with said other battery lead and a second contact terminal electrically contacted by said externally projecting terminal contact portion (18R), such that said externally projecting terminal contact portion (18R) affords spring-biassed engagement with said second contact terminal of said battery and spring-biassed retention of said battery (36) in said cavity.

## Patentansprüche

1. Elektronische Schaltungsbaugruppe bzw. -gehäuse mit
einem Körper aus nicht-leitendem Material, der mehrere Anschlußpins bzw. -beinchen trägt;
einem ersten Anschluß (18P), für einen ersten Energie- bzw. Leistungsanschluß für eine Pufferbatterie bzw. Sicherungsbatterie und einen zweiten Anschluß (18N) für einen zweiten Energie- bzw. Leistungsanschluß der Batterie;
einer integrierten Schaltungseinrichtung (12), die in dem Körper aus nicht-leitendem Material eingekapselt ist, wobei die integrierte Schaltungseinrichtung Knoten hat, die an den ersten und den zweiten Anschluß angeschlossen sind; und
einer Leiterfingeranordnung (18), die in dem Körper aus nicht-leitendem Material eingekapselt sind, wobei die Leiterfingeranordnung mehrere Leiterfinger umfaßt,
dadurch gekennzeichnet, daß:
der Körper aus nicht-leitendem Material einen Schulterabschnitt bzw. Absatzabschnitt (48) aufweist, der einen externen Sockelraum bzw. -hohlraum (44) zum Aufnehmen der Batterie festlegt;
ein erster Leiterfinger (18P) der erste Anschluß ist, und ein zweiter Leiterfinger (18N) der zweite Anschluß ist, wobei einer des ersten Leiterfingers und des zweiten Leiterfingers einen Anschlußkontaktabschnitt (18R) hat, der sich extern zu dem Körper aus nicht-leitendem Material für einen federnd vorgespannten, elektrisch kontaktierenden Eingriff mit dem ersten Energie- bzw. Leistunganschluß und für ein federnd vorgespanntes Zurückhalten der Batterie in dem externen Sockelraum bzw. -hohlraum erstreckt bzw. absteht; wobei der Anschlußkontaktabschnitt (18R) für das Einsetzen und das Entfernen der Batterie auslenkbar ist; und
der Körper aus nicht-leitendem Material durch einen Anschlußraum bzw. -hohlraum (42) für die Batterie in offener Anordnung bzw. Ausrichtung zu bzw. mit dem Batteriesockelraum bzw. -hohlraum (44) unterteilt ist, wobei der Batterieanschlußraum bzw. -hohlraum (42) den anderen des ersten Leiterfingers und des zweiten Leiterfingers für einen elektrisch kontaktierenden Eingriff mit dem zweiten Energie- bzw. Leistungsanschluß von der Batterie freilegt.

2. Elektronische Schaltungsbaugruppe bzw. -gehäuse nach Anspruch 1, in der bzw. in dem die Leiterfingeranordnung (18) eine Grundplatte (22) umfaßt und einer der Leiterfinger (18N) elektrisch an die Grundplatte (22) angeschlossen ist, wobei einer der Knoten der integrierten Schaltungseinrichtung (12) elektrisch an die Grundplatte (22) angekoppelt ist.

3. Elektronische Schaltungsbaugruppe bzw. -gehäuse nach Anspruch 1 oder Anspruch 2, in der bzw. in dem der Schulter- bzw. Absatzabschnitt (48) eine halbzylindrische bzw. teilzylindrische Seitenwand (48H) hat, die eine seitliche Grenzfläche des Sockelraums bzw. -hohlraums festlegt und wobei der Sockelraum bzw. -hohlraum (44) eine ebene Tragfläche (44F) hat, die an die halb- bzw. teilzylindrische Seitenwand angrenzt und eine Bodengrenzfläche des Sockelraums bzw. -hohlraums (44) festlegt, wobei der Batterieanschlußraum bzw. -hohlraum (42) die ebene Tragfläche unterteilt.

4. Elektronische Schaltungsbaugruppe bzw. -gehäuse nach einem der voranstehenden Ansprüche, in der bzw. in dem der Körper aus nicht-leitendem Material eine Kerbe hat, die an dessen Seitenkante ausgebildet ist, wodurch eine freie Öffnung definiert wird, durch die sich der extern erstreckende Anschlußkontaktabschnitt des ersten Leiterfingers zum Eingriff mit der Batterie erstreckt.

5. Elektronische Schaltungsbaugruppe bzw. -gehäuse nach einem der voranstehenden Ansprüche, in der bzw. in dem der eine der Leiterfinger einen Verankerungsstiftabschnitt (18A) hat, der sich quer im Hinblick auf den Energie- bzw. Leistungsleiter erstreckt und der in den Körper aus nicht-leitendem Material eingebettet ist.

6. Elektronische Schaltungsbaugruppe bzw. -gehäuse nach einem der voranstehenden Ansprüche, in der bzw. in dem der zweite Leiterfinger eine leitende Vertiefung hat, die darauf ausgebildet ist, die in dem Batterieanschlußraum bzw. -hohlraum (42) zum Eingriff mit der Batterie angeordnet ist.

7. Elektronische Schaltungsbaugruppe bzw. -gehäuse nach einem der voranstehenden Ansprüche, in der bzw. in dem die integrierte Schaltungseinrichtung (12) eine integrierte LSI-Schaltung ist, die mehrere Eingangs/Ausgangs-Knoten und mehrere Verdrahtungsanschlüsse hat, die die Eingangs/Ausgangs-Knoten an die leitenden Leiterfinger anschließen.

8. Elektronische Schaltungsbaugruppe bzw. -gehäuse nach einem der voranstehenden Ansprüche 2 bis 7, in der bzw. in dem die integrierte Schaltungseinrichtung ein Substrat hat, das an der Grundplatte befestigt bzw. angebondet ist.

9. Verfahren zur Herstellung einer elektronischen Schaltungsbaugruppe bzw. -gehäuses, das aufweist:
ein erster Körper (28) aus nicht-leitendem Material wird ausgebildet, der eine Tragfläche hat;
eine Leiterfingeranordnung (18) wird auf der Tragfläche aufgebaut, wobei die Leiterfingeranordnung mehrere Leiterfinger umfaßt, wobei einer der Leiterfinger (18P) einen positiven Batterieleiter definiert, und ein anderer der Leiterfinger (18N) einen negativen Batterieleiter definiert, und wobei einer der Batterieleiter einen Anschlußkontaktabschnitt (18R) hat, der sich extern von dem ersten Körper (28) aus nicht-leitendem Material erstreckt bzw. davon absteht;
ein zweiter Körper (31) aus nicht-leitendem Material wird auf dem ersten Körper (28) aus nicht-leitendem Material angeordnet, wobei die Leiterfingeranordnung (18) dazwischen aufgenommen bzw. eingeschlossen wird, und wobei der zweite Körper durch einen Einrichtungsraum bzw. -hohlraum zur Aufnahme einer integrierten Schaltungseinrichtung (12) unterteilt wird;
eine integrierte Schaltungseinrichtung (12) wird innerhalb des Einrichtungsraums bzw. -hohlraums abgelegt und mehrere Eingangs/Ausgangs-Knoten der integrierten Schaltungseinrichtung (12) werden an die leitenden Leiterfinger angeschlossen;
wobei der zweite Körper aus nicht-leitendem Material durch einen Batterieanschlußraum bzw. -hohlraum (42) unterteilt wird, der den anderen der Batterieleiter freigibt bzw. freilegt, und wobei der zweite Körper aus nicht-leitendem Material einen Schulter- bzw. Absatzabschnitt (48) hat, der einen Sockelraum bzw. -hohlraum (44) zur Aufnahme einer Pufferbatterie bzw. Sicherungsbatterie festlegt; und das ferner den Schritt aufweist,
daß eine Pufferbatterie bzw. Sicherungsbatterie (36) in den Batterieanschlußraum bzw. -hohlraum eingesetzt wird, wodurch die Batterie einen ersten Kontaktanschluß in elektrischem Kontakt zu dem anderen Batterieleiter und einen zweiten Kontaktanschluß hat, der elektrisch durch den extern abstehenden bzw. erstreckten Anschlußkontaktabschnitt (18R) kontaktiert wird, so daß der extern abstehende bzw. erstreckte Anschlußkontaktabschnitt (18R) einen federvorgespannten Eingriff zu dem zweiten Kontaktanschluß der Batterie und eine federvorgespannte Zurückhaltung der Batterie (36) in dem Raum bzw. Hohlraum aufbringt.

## Revendications

1. Boîtier de circuit électronique comprenant :
un corps de matériau non-conducteur, ce corps portant plusieurs broches de connecteur ;
une première connexion (18P) pour une première borne d'alimentation d'une pile de sauvegarde et une seconde connexion (18N) pour une seconde borne d'alimentation de la pile ;
un dispositif de circuit intégré (12) encapsulé dans le corps de matériau non-conducteur, ce dispositif de circuit intégré ayant des noeuds connectés aux première et seconde connexions ; et
une grille de doigts conducteurs (18) encapsulée dans le corps de matériau non-conducteur, la grille de doigts incluant une pluralité de doigts conducteurs,
caractérisé en ce que :
le corps de matériau non-conducteur a une partie d'épaulement (48) définissant une cavité de douille externe (44) pour recevoir la pile ;
un premier doigt conducteur (18P) constitue la première connexion et un second doigt conducteur (18N) constitue la seconde connexion, l'un des premier et second doigts conducteurs ayant une partie de contact de borne (18R) faisant saillie vers l'extérieur du corps de matériau non-conducteur pour un engagement de contact électrique élastique avec la première borne d'alimentation et pour un maintien sollicité par ressort de la pile dans la cavité de douille externe ; la partie de contact de borne (18R) pouvant être défléchie pour l'insertion et l'enlèvement de la pile ; et
le corps de matériau non-conducteur est coupé par une cavité de connexion de pile (42) en alignement ouvert avec la cavité de douille de pile (44), la cavité de connexion de pile (42) exposant l'autre des premier et second doigts conducteurs pour un engagement de contact électrique avec la seconde borne d'alimentation de la pile.

2. Boîtier de circuit électronique selon la revendication 1, dans lequel la grille de doigts conducteurs (18) comprend une embase (22) et l'un des doigts conducteurs (18N) est électriquement connecté à l'embase (22), l'un des noeuds du dispositif de circuit intégré (12) étant électriquement couplé à l'embase (22).

3. Boîtier de circuit électronique selon la revendication 1 ou 2, dans lequel la partie d'épaulement (48) a une paroi latérale semicylindrique (48H) définissant une limite latérale de la cavité de douille et la cavité de douille (44) a une surface support plane (44F) butant contre la paroi latérale semicylindrique et définissant une frontière de fond de la cavité de douille (44), dans lequel la cavité de connexion de pile (42) coupe la surface support plane.

4. Boîtier de circuit électronique selon l'une quelconque des revendications précédentes, dans lequel le corps de matériau non-conducteur comprend une encoche formée sur sa paroi latérale définissant ainsi une ouverture formant jeu à travers laquelle la partie de contact de borne faisant saillie vers l'extérieur des premiers doigts conducteurs s'étend pour s'engager avec la pile.

5. Boîtier de circuit électronique selon l'une quelconque des revendications précédentes, dans lequel l'un des doigts conducteurs comprend une partie de bossage d'ancrage (18A) s'étendant transversalement par rapport au conducteur d'alimentation et logée dans le corps de matériau non-conducteur.

6. Boîtier de circuit électronique selon l'une quelconque des revendications précédentes, dans lequel le second doigt conducteur comporte une encoche conductrice qui y est formée, disposée dans la cavité de connexion de pile (42) pour entrer en contact avec la pile.

7. Boîtier de circuit électronique selon l'une quelconque des revendications précédentes, dans lequel le dispositif de circuit intégré (12) est un circuit intégré LSI ayant une pluralité de plots d'entrée/sortie, une pluralité de fils conducteurs reliant les plots d'entrée/sortie aux doigts conducteurs.

8. Boîtier de circuit électronique selon l'une quelconque des revendications 2 à 7, dans lequel le dispositif de circuit intégré comporte un substrat qui est lié à l'embase.

9. Procédé de fabrication d'un boîtier de circuit électronique comprenant les étapes suivantes :
former un premier corps (28) en matériau non-conducteur ayant une surface support ;
monter une grille de doigts conducteurs (18) sur la surface support, la grille de doigts conducteurs comprenant une pluralité de doigts conducteurs, l'un des doigts conducteurs (18P) définissant un conducteur positif de pile et l'autre des doigts conducteurs (18N) définissant un conducteur négatif de pile, et l'un des conducteurs de pile ayant une partie de contact de borne (18R) faisant saillie vers l'extérieur du premier corps (28) de matériau non-conducteur ;
assembler un second corps (31) de matériau non-conducteur sur le premier corps (28) de matériau non-conducteur, d'où il résulte que la grille de doigts conducteurs (18) est confinée entre eux et que le second corps est coupé par une cavité de dispositif pour recevoir un dispositif de circuit intégré (12) ;
disposer un dispositif de circuit intégré (12) dans la cavité de dispositif et connecter une pluralité de plots d'entrée/sortie du dispositif de circuit intégré (12) aux doigts conducteurs ;
dans lequel le second corps de matériau non-conducteur est coupé par une cavité de connexion de pile (42) exposant l'autre des conducteurs de pile, et le second corps de matériau non-conducteur comprend des parties d'épaulement (48) définissant une cavité de douille (44) pour recevoir une pile de sauvegarde ; et comprenant en outre l'étape suivante :
insérer une pile de sauvegarde (36) dans la cavité de connexion de pile, d'où il résulte que la pile a une première borne de contact en contact électrique avec l'autre conducteur de pile et une seconde borne de contact contactée électriquement par la partie de contact de borne faisant saillie vers l'extérieur (18R) de sorte que la partie de contact de borne faisant saillie vers l'extérieur (18R) permet une liaison sollicitée par ressort avec la seconde borne de contact de la pile et un maintien sollicité par ressort de la pile (36) dans la cavité.
